# FASCICULE DE BREVET EUROPEEN

(11) **EP 3 499 155 B1**
(45) Date de publication et mention de la délivrance du brevet: **30.12.2020**
(21) Numéro de dépôt: 18208876.5
(22) Date de dépôt: 28.11.2018
(51) Int. Cl.: F25D 3/06, H01L 35/00

(54) **CONTENEUR ISOTHERME DE CONSERVATION ET/OU TRANSPORT DE PRODUITS PÉRISSABLES OU THERMOSENSIBLES**
ISOTHERMISCHER BEHÄLTER ZUR AUFBEWAHRUNG UND/ODER ZUM TRANSPORT VON VERDERBLICHEN ODER THERMOSENSIBLEN PRODUKTEN
INSULATED CONTAINER FOR PRESERVING AND/OR TRANSPORTING PERISHABLE OR HEAT-SENSITIVE PRODUCTS

(30) Priorité: 12.12.2017 FR 1761996
(43) Date de publication de la demande: 19.06.2019
(73) Titulaire: L'AIR LIQUIDE, SOCIETE ANONYME POUR L'ETUDE ET L'EXPLOITATION DES PROCEDES GEORGES CLAUDE, 75007 Paris (FR)
(72) Inventeur: BERNARD, Jean-Pierre, 78280 GUYANCOURT (FR); DALLAIS, Antony, 91640 Janvry (FR)
(74) Mandataire: Air Liquide

(56) Documents cités:
- DE-B3-102016 107 813
- JP-A- 2003 156 272
- KR-B1- 101 682 553
- KR-B1- 101 682 553
- US-A1- 2011 197 624

## Description

L'invention concerne le domaine du transport ou de la distribution des denrées alimentaires périssables et autres plats cuisinés ou aliments en contenants isothermes, ainsi que les produits thermosensibles (médicaments, vaccins,...), qu'il s'agisse par exemple de conteneurs ou de camions, où le maintien de la chaîne du froid est assuré par l'intervention d'un fluide frigorifique (gaz froid, liquide cryogénique tel l'azote liquide, neige carbonique...).

Ainsi à titre d'exemple, les cuisines centrales ou encore les centres de distribution utilisent des chariots isothermes pour transporter et distribuer des plats cuisinés ou des aliments, de leurs cuisines ou plates-formes vers les lieux de consommation : restauration hospitalière, restaurants d'entreprise, scolaires etc....

On ne détaillera pas ici de façon exhaustive les très nombreuses configurations de contenants et de types de refroidissement qui sont disponibles sur le marché, et notamment les types de conteneurs/chariots isothermes, avec ou sans compartiment cryogénique matérialisé, avec ou sans un réservoir ("cassette") comportant le fluide froid à insérer dans le conteneur etc...

Et de même le fluide frigorifique (gaz, liquide cryogénique, solide, qu'il s'agisse d'azote, de CO₂ ou autre...) peut être déposé directement dans le contenant, ou dans un réservoir à insérer dans le contenant, ou envoyé dans un échangeur situé dans le contenant, ou encore, toujours à titre illustratif, envoyé dans une capacité, située dans le contenant lui même ou a proximité (ou encore accolé, par exemple quand le contenant est un camion), capacité à partir de laquelle on prélève du fluide pour l'envoyer vers le contenant, vers un réservoir situé dans le contenant, ou vers un échangeur situé dans le contenant etc....

On le voit à la lecture de ce qui précède les situations et configurations sont très variées.

A titre illustratif on peut néanmoins signaler que les chariots/conteneurs cryogéniques sont très souvent de forme parallélépipédique, ils comprennent très souvent un compartiment cryogénique disposé dans la partie supérieure du conteneur, au-dessus du compartiment de stockage où sont disposés les produits devant être conservés à température contrôlée, et traditionnellement, ce compartiment supérieur reçoit un réservoir destiné à contenir un produit réfrigérant, par exemple du dioxyde de carbone en phase solide, dont la sublimation libère des gaz froids, compensant les entrées de chaleur à travers les joints entre le conteneur et sa porte ou encore à travers les parois isolantes du conteneur. Les plats cuisinés (ou autres produits périssables) sont alors logés dans le compartiment de stockage des produits de ces conteneurs isothermes, qui sont eux même transportés dans des camions vers le site utilisateur (hôpital, cantine scolaire, officine etc......).

Le refroidissement a lieu par contact de l'air avec la plaque froide inférieure du compartiment cryogénique ou par le fait que la face inférieure du compartiment est « ajourée » pour laisser passer du gaz froid vers le compartiment produits.

Selon les versions, le compartiment cryogénique comprend un écran thermique permettant de protéger les denrées stockées.

Les phases de fonctionnement de tels conteneurs sont en général les suivantes :
1- lors de la mise en route du système frigorifique après chargement (par exemple au démarrage d'une tournée ou encore après une ouverture de porte), on adopte un mode de « descente rapide » en température (cette industrie nomme cette phase « pull-down »).
2- Une fois la température de consigne atteinte dans la chambre de stockage des produits, on adopte un mode de contrôle/régulation qui permet de maintenir la température de la chambre de stockage des produits à une valeur de consigne (phase traditionnellement appelée phase de «maintien»).

On sait bien que la réglementation en vigueur concernant le respect de la chaîne du froid pour le transport des denrées alimentaires périssables devient de plus en plus rigoureuse, et conduit notamment les acteurs de telles distributions d'aliments à évoluer en terme de préparation et de traçabilité des produits à transporter.

Le document JP 2003 156272 A constitue un état de l'art pertinent de l'invention.

Les expérimentations menées à bien par la Demanderesse ont permis de démontrer :
- d'une part que les temps de descente en température de tels conteneurs ou chariots, après le chargement du cryogène, sont particulièrement longs, souvent plusieurs heures, et
- d'autre part que les échanges thermiques dans de tels systèmes sont loin d'être optimisés.

Un des objectifs de la présente invention est alors de proposer une solution aux problèmes listés ci-dessus.

Comme on le verra plus en détails dans ce qui suit, la présente invention propose alors de mettre en œuvre les moyens suivants :
- la mise en œuvre d'un (ou plusieurs) ventilateur(s) qui va créer une convection forcée dans le compartiment produit, ce ventilateur étant préférentiellement mis en œuvre uniquement durant les phases de « descente rapide » ;
- la mise en œuvre d'un (ou plusieurs) module(s) « Seebeck », exploitant la différence de température entre le cryogène (par exemple -80°C quand il s'agit de neige carbonique) et la température ambiante initiale dans l'air du chariot au démarrage du processus de refroidissement, permettant la génération d'une tension, tout particulièrement utile pour l'alimentation électrique du ou des ventilateurs en question. Les expérimentations menées par la Demanderesse ont démontré que l'arrêt du ou des ventilateurs est généralement autonome dès lors que la tension générée n'est plus suffisante pour activer ce (ces) ventilateurs, ce qui est généralement le cas en fin de « descente rapide ».

On comprend en effet que au fur et à mesure que la température ambiante diminue dans le compartiment produits (« pull-down ») alors le gradient de température diminue, ce qui fait diminuer la tension générée, ce qui progressivement va provoquer l'arrêt du (des) ventilateur(s) naturellement, et donc permettre une gestion autonome de la ventilation.

On comprend donc que dans certains cas, le (les) ventilateur(s) peut s'arrêter avant la fin de la phase de descente rapide, la phase se poursuit alors sans l'aide de la convection forcée mais par convection naturelle, donc en quelque sorte comme dans l'art antérieur i.e par échange entre l'air refroidi à proximité de la plaque froide qui forme le bas du compartiment cryogénique, et celui plus éloigné au sein du compartiment des produits.

Selon un des modes de mise en œuvre avantageux de l'invention, le chariot est équipé de moyens permettant la mise en place d'un effet radiatif au sein du compartiment produits, par exemple par la présence de plaques métalliques ou d'un revêtement à faible émissivité (peinture...) sur tout ou partie des murs verticaux du chariot, rayonnement tout particulièrement avantageux durant la phase de « maintien ».

Selon un des modes de mise en œuvre de l'invention, l'effet « Seebeck » est obtenu en mettant en œuvre :
- un coté « froid » qui est une surface métallique (par exemple en cuivre, en aluminium ou encore en inox) en contact avec la source froide (i.e l'apport cryogénique) par exemple avec la plaque froide qui forme le bas du compartiment cryogénique ou l'une de ses surfaces latérales; et
- un côté « chaud » qui est assuré par la température du compartiment produits, température qui est préférentiellement maintenue par dissipation du froid à l'aide d'un radiateur par échange avec l'air régnant dans le compartiment produits.

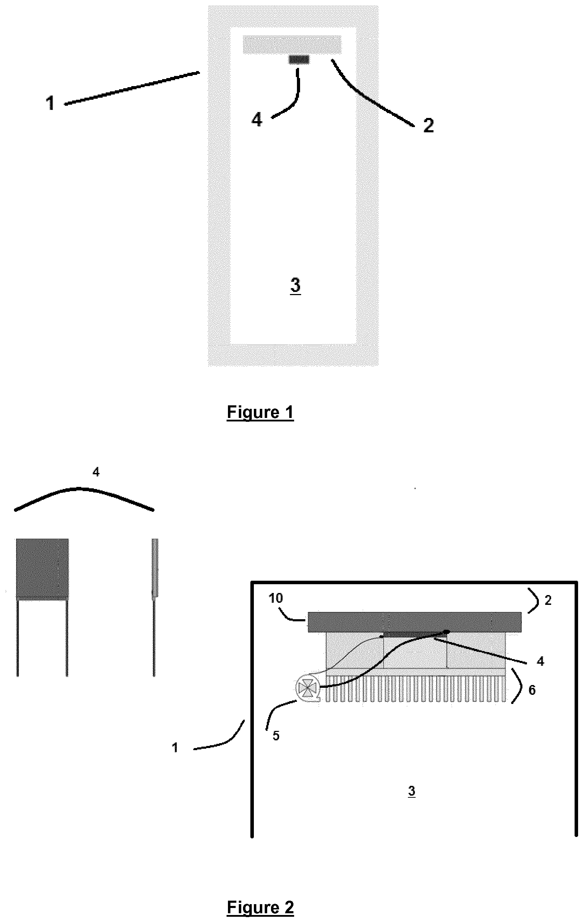

D'autres caractéristiques et avantages ressortiront de la description suivante, donnée uniquement à titre d'exemple et faite en référence aux figures 1 et 2 annexées qui fournissent des représentations schématiques d'un mode de réalisation de l'invention.

On reconnaît sur la figure 1 un schéma global d'un conteneur 1 de conservation et/ou transport de produits périssables (de structure classique parallélépipédique, munie d'une porte d'accès et de chargement non visible sur cette figure très schématique), du type comportant un compartiment cryogénique 2, apte à recevoir une masse d'un cryogène par exemple de la neige carbonique, et un compartiment 3 de stockage des produits à conserver ou transporter, situé dans la partie basse du conteneur, où le refroidissement a lieu par contact de l'air du compartiment produits avec la plaque froide (10 sur la figure 2) constituant la partie inférieure du compartiment cryogénique.

On note sur cette figure la localisation d'un module « Seebeck » 4, que nous détaillerons dans le cadre de la figure 2.

Notons que cette figure 2 est un schéma de principe permettant de détailler et de mieux comprendre une des mises en œuvre de l'invention, elle n'est pas à l'échelle, c'est une sorte de zoom sur la partie « Seebeck » permettant tout simplement de mieux comprendre cette partie.

On reconnait sur cette figure 2 la plaque froide 10 constituant la partie inférieure du compartiment cryogénique 2, au contact de laquelle est positionné le module « Seebeck » 4, dont les deux connecteurs sont reliés au ventilateur 5.

La vue de détails sur la partie gauche de la figure 2 montre un exemple de module Seebeck standard qui peut être utilisé.

On note également la présence d'un radiateur 6, permettant la dissipation du froid et ainsi l'abaissement et/ou le maintien d'une température dans le compartiment produits.

Les expérimentations menées à bien par la Demanderesse ont permis de démontrer qu'un conteneur conforme à l'invention, combinant la présence du ventilateur et du transfert radiatif, a permis d'atteindre les résultats suivants :
- une augmentation de la vitesse de descente en température du compartiment produits, après chargement du cryogène, voisine de +17% .
- une réduction de la durée de la phase de « descente rapide » voisine de 45mn .
- s'agissant de la phase de maintien, une augmentation de la durée de cette phase (donc de la stabilité de la température au voisinage de la consigne souhaitée) voisine de +58%.
- globalement une consommation de neige carbonique diminuée d'au moins 22%, pour une performance en maintien augmentée de 58 % comme signalé ci-dessus.

Cette masse plus faible de cryogène embarqué permet par ailleurs d'augmenter d'autant la charge utile transportée et a un effet bénéfique direct sur le cout de la solution technique proposée ici.

## Revendications

1. Conteneur isotherme (1) de conservation et/ou transport de produits périssables ou thermosensibles, du type comportant un compartiment cryogénique (2), apte à recevoir une masse d'un cryogène par exemple de la neige carbonique, et un compartiment de stockage des produits (3) à conserver ou transporter, où le refroidissement a lieu par contact de l'air du compartiment de stockage des produits avec une plaque froide (10) constituant la partie inférieure du compartiment cryogénique, le conteneur isolant comportant moins un ventilateur (5), positionné(s) au sein du compartiment de stockage des produits pour pouvoir créer une convection forcée dans le compartiment de stockage des produits ; **caractérisé en ce que** le conteneur isotherme comporte en outre au moins un module « Seebeck » (4), exploitant la différence de température entre ladite masse de cryogène et la température ambiante dans l'air du compartiment de stockage des produits, permettant la génération d'une tension, utilisable pour l'alimentation électrique du ou des ventilateurs, l'effet « Seebeck » étant obtenu en mettant en œuvre :
- un coté « froid » qui est une surface métallique, constituant une partie du module « Seebeck », et qui est en contact avec la source froide constituée par la masse de cryogène, par exemple en étant en contact avec la plaque froide (10) constituant la partie inférieure du compartiment cryogénique ou avec l'une des surfaces latérales de ce compartiment cryogénique;
- un côté « chaud » qui est assuré par la température de l'atmosphère au sein du compartiment de stockage des produits.

2. Conteneur selon la revendication 1, **se caractérisant en ce qu'**il comprend, au sein du compartiment de stockage des produits, un radiateur (6), permettant la dissipation du froid et ainsi l'abaissement et/ou le maintien d'une température dans le compartiment de stockage des produits.

3. Conteneur selon l'une des revendications précédentes, **se caractérisant en ce que** le compartiment cryogénique est apte à accueillir un réservoir cryogénique, pouvant être chargé en ladite masse de cryogène.

4. Conteneur selon l'une des revendications précédentes, **se caractérisant en ce qu'**il est muni de moyens permettant la mise en place d'un effet radiatif au sein du compartiment de stockage des produits, par exemple par la présence de plaques métalliques ou d'un revêtement à faible émissivité sur tout ou partie des murs verticaux du conteneur.

5. Conteneur selon l'une des revendications précédentes, **se caractérisant en ce que** le ou les ventilateurs est (sont) mis en œuvre uniquement durant des phases de « descente rapide » de la température au sein du compartiment de stockage des produits.

## Patentansprüche

1. Isothermer Behälter (1) zur Aufbewahrung und/oder zum Transport von verderblichen oder thermosensiblen Produkten der Art, die ein Kryofach (2), das ausgelegt ist, um eine Masse kryogenen Fluids, zum Beispiel Trockeneis, zu empfangen, und ein Fach zum Lagern der Produkte (3), die aufbewahrt oder transportiert werden sollen, umfasst, bei dem die Abkühlung durch Kontakt der Luft des Fachs zum Lagern der Produkte mit einer kalten Platte (10) erfolgt, die den unteren Teil des Kryofachs darstellt, wobei der isolierende Behälter mindestens einen Ventilator (5) umfasst, der (die) im Inneren des Fachs zum Lagern der Produkte positioniert ist (sind), um eine Zwangskonvektion im Fach zum Lagern der Produkte erzeugen zu können;
**dadurch gekennzeichnet, dass** der isotherme Behälter weiter mindestens ein "Seebeck"-Modul (4) umfasst, das die Temperaturdifferenz zwischen der Masse kryogenen Fluids und der Umgebungstemperatur in der Luft des Fachs zum Lagern der Produkte nutzt, die die Erzeugung einer Spannung ermöglicht, die für die elektrische Versorgung des Ventilators oder der Ventilatoren verwendet werden kann, wobei der "Seebeck"-Effekt erhalten wird, indem Folgendes eingesetzt wird:
- eine "kalte" Seite, bei der es sich um eine metallische Fläche handelt, die einen Teil des "Seebeck"-Moduls darstellt und die mit der kalten Quelle in Kontakt steht, die von der Masse kryogenen Fluids dargestellt wird, zum Beispiel indem sie mit der kalten Platte (10), die den unteren Teil des Kryofachs darstellt, oder mit einer der seitlichen Flächen dieses Kryofachs in Kontakt steht;
- eine "warme" Seite, die von der Temperatur der Atmosphäre im Inneren des Fachs zum Lagern der Produkte sichergestellt ist.

2. Behälter nach Anspruch 1, **dadurch gekennzeichnet, dass** er im Inneren des Fachs zum Lagern der Produkte einen Heizkörper (6) umfasst, der die Ableitung der Kälte und somit die Absenkung und/oder die Beibehaltung einer Temperatur im Fach zum Lagern der Produkte ermöglicht.

3. Behälter nach einem der vorstehenden Ansprüche, **dadurch gekennzeichnet, dass** das Kryofach ausgelegt ist, um einen Kryobehälter aufzunehmen der mit der Masse kryogenen Fluids beladen werden kann.

4. Behälter nach einem der vorstehenden Ansprüche, **dadurch gekennzeichnet, dass** er mit Mitteln ausgestattet ist, die die Durchführung eines Strahlungseffekts im Inneren des Fachs zum Lagern der Produkte ermöglicht, zum Beispiel durch die Anwesenheit von metallischen Platten oder einer Verkleidung mit geringem Emissionsvermögen auf der Gesamtheit oder einem Teil der vertikalen Wände des Behälters.

5. Behälter nach einem der vorstehenden Ansprüche, **dadurch gekennzeichnet, dass** der Ventilator oder die Ventilatoren nur während Phasen der "rapiden Absenkung" der Temperatur im Inneren des Fachs zum Lagern der Produkte eingesetzt wird (werden).

## Claims

1. Insulated container (1) for preserving and/or transporting perishable or heat-sensitive products, of the type comprising a cryogenic compartment (2), capable of receiving a mass of a cryogen, for example, dry ice, and a compartment for storing products (3) to be preserved or transported, where the cooling occurs by contact of air of the compartment for storing products with a cold plate (10) constituting the lower portion of the cryogenic compartment, the insulating container comprising at least one fan (5), positioned within the compartment for storing products in order to be able to create a forced convection in the compartment for storing products;
**characterised in that** the insulated container further comprises at least one "Seebeck" module (4), utilising the temperature difference between said mass of cryogen and the ambient temperature in the air of the compartment for storing products, allowing the generation of a voltage which can be used for the electric supply of the fan(s), the "Seebeck" effect being obtained by implementing:
- a "cold" side which is a metal surface, constituting a portion of the "Seebeck" module, and which is in contact with the cold source formed by the mass of cryogen, for example by being in contact with the cold plate (10) constituting the lower portion of the cryogenic compartment or with one of the side surfaces of this cryogenic compartment;
- a "hot" side which is provided by the temperature of the atmosphere within the compartment for storing products.

2. Container according to claim 1, **characterised in that** it comprises, within the compartment for storing products, a radiator (6), allowing the dissipation of the cold and thus the lowering and/or the maintaining of a temperature in the compartment for storing products.

3. Container according to one of the preceding claims, **characterised in that** the cryogenic compartment is capable of housing a cryogenic tank, which can be loaded with said mass of cryogen.

4. Container according to one of the preceding claims, **characterised in that** it is provided with means allowing the implementation of a radiative effect within the compartment for storing products, for example by the presence of metal plates or a coating with low emissivity over all or part of the vertical walls of the container.

5. Container according to one of the preceding claims, **characterised in that** the fan(s) is/are used only during "rapid descent" phases of the temperature within the compartment for storing products.
